# EUROPÄISCHE PATENTSCHRIFT

(11) **EP 3 762 171 B1**
(45) Veröffentlichungstag und Bekanntmachung des Hinweises auf die Patenterteilung: **21.06.2023**
(21) Anmeldenummer: 18708986.7
(22) Anmeldetag: 05.03.2018
(51) Int. Cl.: B23K 1/00, B23K 1/20, B23K 35/36, H05K 3/30, H05K 3/34, H05K 1/03

(54) **VERFAHREN ZUR HERSTELLUNG EINER SANDWICHANORDNUNG**
METHOD FOR PRODUCING A SANDWICH ARRANGEMENT
PROCÉDÉ DE FABRICATION D'UN ENSEMBLE SANDWICH

(43) Veröffentlichungstag der Anmeldung: 13.01.2021
(73) Patentinhaber: Heraeus Deutschland GmbH & Co. KG, 63450 Hanau (DE)
(72) Erfinder: SCHÄFER, Michael, 36093 Künzell (DE); PELSHAW, Nadja, 63505 Langenselbold (DE); LÖWER, Yvonne, 63526 Erlensee (DE); MIRIC, Anton-Zoran, 63755 Alzenau (DE)
(74) Vertreter: Heraeus IP
(86) Internationale Anmeldenummer: PCT/EP2018/055249
(87) Internationale Veröffentlichungsnummer: WO 2019/170213

(56) Entgegenhaltungen:
- WO-A1-2017/057649
- US-A- 5 865 365

## Beschreibung

Die Erfindung betrifft ein Verfahren zur Herstellung einer Sandwichanordnung aus einem ersten über Lot mit einem zweiten Bauelement verbundenen Bauelement.

Löten als Methode zum stoffschlüssigen Verbinden von Bauelementen ist dem Fachmann bekannt. Insbesondere handelt es sich um eine Methode, um in der Elektronik verwendete Bauelemente über eine jeweilige Kontaktfläche mechanisch sowie wärme- und elektrisch leitend miteinander zu verbinden. Als Lotmaterial kann eine zwischen den zu verbindenden Bauelementen befindliche Lotpaste oder platzierte Lotvorform verwendet werden, die in einem Ofen zu geschmolzenem Lot aufgeschmolzen wird und nach Verlassen des Ofens, Abkühlen und Erstarren die gewünschte Verbindung der Bauelemente ergibt. Alternativ dazu kann eine auf ein Bauelement applizierte Lotpaste oder platzierte Lotvorform zunächst in ein mit einer Kontaktfläche des Bauelements verbundenes Lotdepot umgewandelt werden. Das mit der Kontaktfläche des Bauelements verbundene Lotdepot hat eine nach außen weisende freie Kontaktfläche und kann so als die Herstellung einer Lötverbindung zum weiteren Bauelement ermöglichendes Lotmaterial dienen. Dazu kann es in einem Ofen zu geschmolzenem Lot aufgeschmolzen werden und nach Verlassen des Ofens, Abkühlen und Erstarren die gewünschte Verbindung der Bauelemente bilden. Problematisch ist, dass es beim Bewegen der Anordnung aus Bauelement oder -elementen und Lotvorform, beispielsweise beim Transport in den Ofen, zu einer unerwünschten Positionsveränderung zwischen Lotvorform und zu verbindenden Bauelementen kommen kann; nicht anders verhält es sich beim Bewegen oder beim Transport einer Anordnung aus mit Lotdepot ausgestattetem Bauelement und damit zu verbindendem weiteren Bauelement. Im ungünstigsten Fall kann sich ein Bauelement nicht nur gegenüber Lotvorform und zu verbindendem Bauelement oder gegenüber einem Lotdepot verschieben oder eine Schieflage annehmen, sondern sich sogar lösen und herunter fallen. Ursachen können beispielsweise Erschütterungen oder Beschleunigungs- bzw. Abbremsvorgänge während des Transports sein.

US 5,255,839 offenbart die Applikation von Klebewirkung aufweisendem Flussmittel auf das Lotdepot eines Substrats vor der Bestückung dessen mit einer Komponente und deren Verlöten mit dem Substrat. Das Lotdepot wird zuvor durch Reflow-Löten von auf eine Kontaktfläche des Substrats bedeckendes Flussmittel applizierten Lotkugeln erzeugt.

US 5,177,134 offenbart die Verwendung eines zum temporären Verbinden von Elektronikkomponenten geeigneten Klebstoffs mit Flussmitteleigenschaften beim Lötverbinden der Elektronikkomponenten. Wesentlicher Bestandteil des Klebstoffs ist eine 2,2-disubstituierte Bernsteinsäure.

WO2017057649 offenbart ein Verfahren zur Herstellung einer Sandwichanordnung.

Aufgabe der Erfindung ist die Entwicklung eines Verfahrens zur Herstellung einer Sandwichanordnung aus zwei Bauelementen mit dazwischen befindlichem Lot, bei dem intermediär ein Fixiermittel verwendet wird, welches einen Verzicht auf die Verwendung eines Flussmittels und die Herstellung einer zufriedenstellenden Lötverbindung zwischen den beiden Bauelementen erlaubt. Im Kontext der vorliegenden Offenbarung bedeutet "zufriedenstellende Lötverbindung" eine Lötverbindung ohne oder mit einer nach Anzahl und Größe nur geringe Menge an Lunkerfehlstellen an der Grenzfläche zwischen Bauelement und Lot. Solche Lunkerfehlstellen können die mechanische, die elektrische und/oder die wärmeleitende Verbindung stören. Das Fixiermittel soll möglichst in vergleichsweise geringer Menge eingesetzt werden können.

Es hat sich gezeigt, dass das nachstehend offenbarte erfindungsgemäße Verfahren die Aufgabe lösen kann. Einer der Schlüssel zur Lösung liegt in der Verwendung eines mit einem Flussmittel nicht zu verwechselnden, d.h. eines kein Flussmittel darstellenden, weil keine Flussmittelwirkung (d.h. keine vor und/oder während des Lötens Lotmetalloxid oder Lotmetalloxidschicht auflösende respektive beseitigende Wirkung) aufweisenden, aus einer Fixiermittelzusammensetzung applizierbaren Fixiermittels zur Fixierung einer Lotvorform an einem Bauelement während eines an sich bekannten Prozesses zur Umwandlung derselben in ein mit einem Bauelement verbundenes Lotdepot, insbesondere während damit einhergehender Transportschritte. Es hat sich gezeigt, dass das Fixiermittel eine Fixierung im Sinne einer temporär hinreichenden Anhaftung einer Lotvorform an einem mit Lotdepot auszustattenden Bauelement erlaubt, was sich in der Praxis als deutlich verringerte Produktion von Ausschuss ausdrückt im Vergleich zum Arbeiten ohne Fixiermittel. Im Übrigen kann, wie sich auch gezeigt hat, beim Arbeiten mit Fixiermittel auf die Verwendung aufwändiger mechanischer Fixiereinrichtungen verzichtet werden. Es hat sich ferner gezeigt, dass die dem erfindungsgemäßen Verfahren entsprechende Verwendung des Fixiermittels geringfügige bis tolerierbare Einflüsse auf die mechanische, thermische bzw. elektrische Verbindung und Performance mit Lotdepot versehener Bauelemente oder daraus hergestellter fertiger verlöteter Sandwichanordnungen von Bauelementen hat.

Das nachfolgend offenbarte erfindungsgemäße Verfahren kann ohne Verwendung von Flussmittel durchgeführt werden.

Die Erfindung ist in den Ansprüchen definiert.

Die hierin verwendeten Begriffe "organische Verbindung" und "organisches Polymer" können auch Stoffe mit organischen und anorganischen Anteilen umfassen; lediglich rein anorganische Stoffe sind von den Begriffen nicht umfasst.

Der hierin verwendete Begriff "Polymere" umfasst auch Oligomere; beide sind nicht mit nichtpolymeren Verbindungen zu verwechseln. Die Grenze zwischen Oligomeren und Polymeren wird hierin durch das Gewichtsmittel der Molmasse, bestimmbar mittels GPC (Gelpermeationschromatographie, Polystyrolstandards, Polystyrolgel als stationäre Phase, Tetrahydrofuran als mobile Phase) definiert. Polymere haben eine gewichtsmittlere Molmasse Mw über 1000, beispielsweise im Bereich von 1000 bis 300.000, Oligomere haben eine gewichtsmittlere Molmasse Mw von <1000, beispielsweise im Bereich von 500 bis <1000.

Im Gegensatz zu Polymeren und Oligomeren handelt es sich bei nichtpolymeren Verbindungen um niedermolekulare Verbindungen mit definierter Summen- und Strukturformel.

Der hierin verwendete Ausdruck "ohne saure Gruppen" bedeutet ohne Funktionalitäten, die als Protonendonator fungieren und in Wasser H₃O⁺-Ionen bilden können, wie beispielsweise Carboxylgruppen, Sulfonsäuregruppen, phenolische OH-Gruppen und dergleichen.

Der hierin im Zusammenhang mit Verbindungen vom Typ (iv) verwendete Ausdruck "ohne Siedepunkt" bezieht sich auf solche Vertreter, die anstelle eines Siedepunktes lediglich einen Zersetzungspunkt oder -bereich aufweisen.

Im erfindungsgemäßen Verfahren wird also eine Lotvorform mittels besagten Fixiermittels an einer Kontaktfläche A oder D eines Bauelements fixiert, dann geschmolzen und das so gebildete geschmolzene Lot unter seine Erstarrungstemperatur abgekühlt. Im Ergebnis erhält man ein mit einem Lotdepot an seiner Kontaktfläche A respektive D ausgestattetes Bauelement. Dieses wird mit der freien Kontaktfläche seines Lotdepots zu der Kontaktfläche D respektive A eines zu verbindenden Bauelements gewandt angeordnet, wobei sich Fixiermittel zwischen den zu verbindenden Kontaktflächen befinden kann. Danach wird das Lotdepot geschmolzen und das so gebildete geschmolzene Lot unter seine Erstarrungstemperatur abgekühlt, wodurch die fertige verlötete Sandwichanordnung gebildet wird.

Im Rahmen der Erfindung soll der Begriff "Bauelement" vorzugsweise Einzelteile umfassen. Diese Einzelteile sind vorzugsweise nicht weiter zerlegbar. Es handelt sich bei den Bauelementen insbesondere um Bauelemente oder Bauteile, die in der Elektronik verwendet werden. Die Bauelemente haben Kontaktflächen, insbesondere metallische Kontaktflächen.

Hierin wird zwischen einem Bauelement mit einer Kontaktfläche A und einem davon verschiedenen respektive davon unterscheidbaren Bauelement mit einer Kontaktfläche D unterschieden. Um Missverständnissen vorzubeugen, Bauelemente mit Kontaktfläche können nur dann nicht voneinander unterscheidbar sein, wenn sie - als freie Bauelemente betrachtet - identisch sind oder wenn sie zueinander symmetrisch angeordnet vorliegen. Liegen sie nicht in zueinander symmetrischer Anordnung vor, so können auch identische Bauelemente voneinander unterscheidbar sein.

Das Bauelement mit einer Kontaktfläche A und das Bauelement mit einer Kontaktfläche D können von derselben Art sein, d.h. es kann sich beispielsweise in beiden Fällen um Substrate handeln, oder es handelt sich jeweils um aktive oder passive Bauelemente oder um ein aktives und ein passives Bauelement. Es kann aber auch sein, dass es sich bei dem Bauelement mit einer Kontaktfläche A um ein Substrat und bei dem Bauelement mit einer Kontaktfläche D um ein aktives oder passives Bauelement handelt, oder umgekehrt. Bei den Substraten, den aktiven und den passiven Bauelementen handelt es sich insbesondere um Teile, die in der Elektronik verwendet werden.

Beispielsweise lassen sich so folgende Ausführungsformen unterscheiden:

| **Bauelement mit Kontaktfläche A:** | **Bauelement mit Kontaktfläche D:** |
|---|---|
| Substrat | Substrat |
| Aktives Bauelement | Passives Bauelement |
| Passives Bauelement | Aktives Bauelement |
| Aktives Bauelement | Aktives Bauelement |
| Passives Bauelement | Passives Bauelement |
| Substrat | Aktives Bauelement |
| Substrat | Passives Bauelement |
| Passives Bauelement | Substrat |
| Aktives Bauelement | Substrat |

Beispiele für Substrate sind IMS-Substrate (insulated metal-Substrate, isolierte Metallsubstrate), DCB-Substrate (direct copper bonded-Substrate), Keramiksubstrate, PCBs (printed circuit boards, gedruckte Leiterplatten) und Leadframes. Die Größen der Kontaktflächen liegen beispielsweise im Bereich von 0,01 bis 200 cm². Die Form der Kontaktflächen kann beliebig sein, beispielsweise rund, sechseckig, dreieckig, bevorzugt rechteckig.

Beispiele für aktive Bauelemente sind Dioden, LEDs (light emitting diodes, Leuchtdioden), Dies (Halbleiterchips), IGBTs (insulated-gate bipolar transistors, Bipolartransistoren mit isolierter Gate-Elektrode), ICs (integrated circuits, integrierte Schaltungen) und MOSFETs (metal-oxide-semiconductor field-effect transistors, Metall-Oxid-Halbleiter-Feldeffekttransistoren). Die Größen der Kontaktflächen liegen beispielsweise im Bereich von 0,01 bis 200 cm². Die Form der Kontaktflächen kann beliebig sein, beispielsweise rund, sechseckig, dreieckig, bevorzugt rechteckig.

Beispiele für passive Bauelemente sind Sensoren, Bodenplatten, Kühlkörper, Verbindungselemente (z. B. Clips), Widerstände, Kondensatoren, Induktoren und Antennen. Die Größen der Kontaktflächen liegen beispielsweise im Bereich von 0,01 bis 200 cm². Die Form der Kontaktflächen kann beliebig sein, beispielsweise rund, sechseckig, dreieckig, bevorzugt rechteckig.

Bei Lot handelt es sich um Lotmetall, beispielsweise Zinn oder zinnreiche Legierungen. Beispiele für zinnreiche Legierungen sind solche mit einem Zinnanteil beispielsweise im Bereich von 90 bis 99,5 Gew.-% (Gewichts-%). Beispiele für Legierungsmetalle sind Kupfer, Silber, Indium, Germanium, Nickel, Blei, Bismut und Antimon. Die Legierungen können bleihaltig oder bleifrei sein. Bleifreie Legierungen können beispielsweise ausgewählt sein aus der Gruppe bestehend aus SnAg, SnBi, SnSb, SnAgCu, SnCu, SnSb, InSnCd, InBiSn, InSn, BiSnAg oder SnAgCuBiSbNi. Bleihaltige Legierungen können beispielsweise ausgewählt sein aus der Gruppe umfassend SnPb und SnPbAg. Die Schmelztemperaturen der Lote können beispielsweise im Bereich von 150 bis 500°C, insbesondere 170 bis 350°C liegen.

Bei Lotvorformen handelt es sich um Lotmetall in Form von Formteilen, beispielsweise Lotmetallfolie, Lotmetallband, Lotmetallplättchen oder Lotmetallzylinder. Die Lotvorformen haben diskrete Kontaktflächen B und C, d.h. es handelt sich um voneinander separate und unterscheidbare Kontaktflächen B und C, beispielsweise auf einander gegenüberliegenden Seiten einer Lotvorform angeordnete Kontaktflächen B und C. Die Größen der Kontaktflächen vom Typ B und C liegen jeweils beispielsweise im Bereich von 0,01 bis 200 cm². Die Form der Kontaktflächen vom Typ B und C kann beliebig sein, beispielsweise rund, sechseckig, dreieckig, bevorzugt rechteckig.

Die Dicke der Lotvorform kann beispielsweise im Bereich von 10 bis 750 µm liegen.

In einer ersten Ausführungsform umfasst das erfindungsgemäße Verfahren die aufeinanderfolgenden Schritte:
(1) Bereitstellen eines ersten Bauelements mit einer Kontaktfläche A, eines zweiten Bauelements mit einer Kontaktfläche D, einer wie vorerwähnt zusammengesetzten (d.h. zum Applizieren des Fixiermittels geeigneten) Fixiermittelzusammensetzung sowie einer Lotvorform mit diskreten jeweils nicht mit Fixiermittel versehenen Kontaktflächen B und C,
(2) Applizieren des Fixiermittels aus der Fixiermittelzusammensetzung auf die Kontaktflächen A und/oder B,
(3) Platzieren der Lotvorform mit ihrer Kontaktfläche B auf die Kontaktfläche A mit dem Fixiermittel zwischen den Kontaktflächen A und B,
(4) Schmelzen der fixierten Lotvorform unter Bildung geschmolzenen Lots,
(5) Abkühlen des geschmolzenen Lots unter seine Erstarrungstemperatur unter Bildung eines Lotdepots mit einer freien Kontaktfläche X,
(6) gegebenenfalls Applizieren des Fixiermittels aus der Fixiermittelzusammensetzung auf die Kontaktflächen D und/oder X,
(7) Herstellen einer Sandwichanordnung aus den beiden Bauelementen mit dem dazwischen befindlichen Lotdepot durch Anordnen der Kontaktflächen X und D in zueinander gewandter Position mit dem gegebenenfalls dazwischen befindlichen Fixiermittel,
(8) Schmelzen des Lotdepots unter Bildung geschmolzenen Lots, und
(9) Abkühlen des geschmolzenen Lots unter seine Erstarrungstemperatur unter Bildung einer Sandwichanordnung aus den beiden über ihre Kontaktflächen A und D und das dazwischen befindliche erstarrte Lot verbundenen Bauelementen.

Hierin wird der Ausdruck "mit Fixiermittel versehen" respektive "nicht mit Fixiermittel versehen" verwendet. Er sagt aus, ob eine oder mehrere betreffende Kontaktflächen mit Fixiermittel ausgestattet oder frei davon sind, mit anderen Worten, ob Fixiermittel auf eine oder mehrere betreffende Kontaktflächen appliziert worden ist oder nicht.

In einer zweiten Ausführungsform umfasst das erfindungsgemäße Verfahren die aufeinanderfolgenden Schritte:
(1) Bereitstellen eines ersten Bauelements mit einer Kontaktfläche A, eines zweiten Bauelements mit einer Kontaktfläche D, einer wie vorerwähnt zusammengesetzten (d.h. zum Applizieren des Fixiermittels geeigneten) Fixiermittelzusammensetzung sowie einer Lotvorform mit diskreten jeweils nicht mit Fixiermittel versehenen Kontaktflächen B und C,
(2) Applizieren des Fixiermittels aus der Fixiermittelzusammensetzung auf die Kontaktflächen C und/oder D,
(3) Platzieren der Lotvorform mit ihrer Kontaktfläche C auf die Kontaktfläche D mit dem Fixiermittel zwischen den Kontaktflächen C und D,
(4) Schmelzen der fixierten Lotvorform unter Bildung geschmolzenen Lots,
(5) Abkühlen des geschmolzenen Lots unter seine Erstarrungstemperatur unter Bildung eines Lotdepots mit einer freien Kontaktfläche Y,
(6) gegebenenfalls Applizieren des Fixiermittels aus der Fixiermittelzusammensetzung auf die Kontaktflächen A und/oder Y,
(7) Herstellen einer Sandwichanordnung aus den beiden Bauelementen mit dem dazwischen befindlichen Lotdepot durch Anordnen der Kontaktflächen Y und A in zueinander gewandter Position mit dem gegebenenfalls dazwischen befindlichen Fixiermittel,
(8) Schmelzen des Lotdepots unter Bildung geschmolzenen Lots, und
(9) Abkühlen des geschmolzenen Lots unter seine Erstarrungstemperatur unter Bildung einer Sandwichanordnung aus den beiden über ihre Kontaktflächen A und D und das dazwischen befindliche erstarrte Lot verbundenen Bauelementen.

In einer dritten Ausführungsform umfasst das erfindungsgemäße Verfahren die aufeinanderfolgenden Schritte:
(1) Bereitstellen eines ersten Bauelements mit einer Kontaktfläche A, eines zweiten Bauelements mit einer Kontaktfläche D, einer Lotvorform mit diskreten Kontaktflächen B und C, wovon nur die Kontaktfläche B mit dem Fixiermittel versehen ist, sowie gegebenenfalls einer wie vorerwähnt zusammengesetzten (d.h. zum Applizieren des Fixiermittels geeigneten) Fixiermittelzusammensetzung,
(2) gegebenenfalls Applizieren des Fixiermittels aus der Fixiermittelzusammensetzung auf die Kontaktfläche A,
(3) Platzieren der Lotvorform mit ihrer Kontaktfläche B auf die Kontaktfläche A mit dem Fixiermittel zwischen den Kontaktflächen A und B,
(4) Schmelzen der fixierten Lotvorform unter Bildung geschmolzenen Lots,
(5) Abkühlen des geschmolzenen Lots unter seine Erstarrungstemperatur unter Bildung eines Lotdepots mit einer freien Kontaktfläche X,
(6) gegebenenfalls Applizieren des Fixiermittels aus der Fixiermittelzusammensetzung auf die Kontaktflächen D und/oder X,
(7) Herstellen einer Sandwichanordnung aus den beiden Bauelementen mit dem dazwischen befindlichen Lotdepot durch Anordnen der Kontaktflächen X und D in zueinander gewandter Position mit dem gegebenenfalls dazwischen befindlichen Fixiermittel,
(8) Schmelzen des Lotdepots unter Bildung geschmolzenen Lots, und
(9) Abkühlen des geschmolzenen Lots unter seine Erstarrungstemperatur unter Bildung einer Sandwichanordnung aus den beiden über ihre Kontaktflächen A und D und das dazwischen befindliche erstarrte Lot verbundenen Bauelementen.

In einer vierten Ausführungsform umfasst das erfindungsgemäße Verfahren die aufeinanderfolgenden Schritte:
(1) Bereitstellen eines ersten Bauelements mit einer Kontaktfläche A, eines zweiten Bauelements mit einer Kontaktfläche D, einer Lotvorform mit diskreten Kontaktflächen B und C, wovon nur die Kontaktfläche C mit dem Fixiermittel versehen ist, sowie gegebenenfalls einer wie vorerwähnt zusammengesetzten (d.h. zum Applizieren des Fixiermittels geeigneten) Fixiermittelzusammensetzung,
(2) gegebenenfalls Applizieren des Fixiermittels aus der Fixiermittelzusammensetzung auf die Kontaktfläche D,
(3) Platzieren der Lotvorform mit ihrer Kontaktfläche C auf die Kontaktfläche D mit dem Fixiermittel zwischen den Kontaktflächen C und D,
(4) Schmelzen der fixierten Lotvorform unter Bildung geschmolzenen Lots,
(5) Abkühlen des geschmolzenen Lots unter seine Erstarrungstemperatur unter Bildung eines Lotdepots mit einer freien Kontaktfläche Y,
(6) gegebenenfalls Applizieren des Fixiermittels aus der Fixiermittelzusammensetzung auf die Kontaktflächen A und/oder Y,
(7) Herstellen einer Sandwichanordnung aus den beiden Bauelementen mit dem dazwischen befindlichen Lotdepot durch Anordnen der Kontaktflächen Y und A in zueinander gewandter Position mit dem gegebenenfalls dazwischen befindlichen Fixiermittel,
(8) Schmelzen des Lotdepots unter Bildung geschmolzenen Lots, und
(9) Abkühlen des geschmolzenen Lots unter seine Erstarrungstemperatur unter Bildung einer Sandwichanordnung aus den beiden über ihre Kontaktflächen A und D und das dazwischen befindliche erstarrte Lot verbundenen Bauelementen.

Die vorerwähnten vier Ausführungsformen des erfindungsgemäßen Verfahrens stellen definierte Schrittfolgen dar, welche die jeweiligen aufeinanderfolgenden Schritte (1) bis (9) umfassen oder daraus bestehen. Es kann sich bei besagten neun Schritten um direkt aufeinander folgende Schritte handeln, d.h. ohne Zwischenschritte oder zumindest ohne wesentliche Zwischenschritte, also ohne das Wesen des erfindungsgemäßen Verfahrens verändernde Zwischenschritte. Allerdings können Teilschritte des Bereitstellungsschritts (1) eine Ausnahme dergestalt bilden, dass sie, soweit es die weitere Schrittfolge erlaubt oder sogar erfordert, an geeigneter Stelle im Verfahren stattfinden oder abgeschlossen werden und so Bereitstellungsschritt (1) zum vollständigen Abschluss bringen können.

Die vorliegende Offenbarung umfasst neben den mit dem erfindungsgemäßen Verfahren herstellbaren Sandwichanordnungen auch Anordnungen, die als Zwischenprodukte des erfindungsgemäßen Verfahrens erhalten werden oder auftreten können.

Eine solche als Zwischenprodukt bei der ersten und dritten Ausführungsform des erfindungsgemäßen Verfahrens erhältliche Anordnung umfasst eine Anordnung aus einem Bauelement mit einer Kontaktfläche A und einem mit dieser Kontaktfläche A verbundenen Lotdepot mit einer freien Kontaktfläche X, die mit dem Fixiermittel versehen ist.

Eine weitere solche als Zwischenprodukt bei der ersten und dritten Ausführungsform des erfindungsgemäßen Verfahrens erhältliche Anordnung umfasst eine Anordnung aus einem ersten Bauelement mit einer Kontaktfläche A und einem zweiten Bauelement mit einer Kontaktfläche D und einem zwischen den Kontaktflächen A und D angeordneten mit der Kontaktfläche A verbundenen Lotdepot, welches mit seiner freien Kontaktfläche X zur Kontaktfläche D weisend mittels des Fixiermittels verbunden ist. Mit anderen Worten, es handelt sich um eine unverlötete Sandwichanordnung aus einem Bauelement mit einem mit seiner Kontaktfläche A verbundenen Lotdepot mit einer freien Kontaktfläche X, die wiederum mittels des Fixiermittels mit der Kontaktfläche D des anderen Bauelements verbunden ist.

Eine weitere solche als Zwischenprodukt bei der zweiten und vierten Ausführungsform des erfindungsgemäßen Verfahrens erhältliche Anordnung umfasst eine Anordnung aus einem Bauelement mit einer Kontaktfläche D und einem mit dieser Kontaktfläche D verbundenen Lotdepot mit einer freien Kontaktfläche Y, die mit dem Fixiermittel versehen ist.

Eine weitere solche als Zwischenprodukt bei der zweiten und vierten Ausführungsform des erfindungsgemäßen Verfahrens erhältliche Anordnung umfasst eine Anordnung aus einem ersten Bauelement mit einer Kontaktfläche A und einem zweiten Bauelement mit einer Kontaktfläche D und einem zwischen den Kontaktflächen A und D angeordneten mit der Kontaktfläche D verbundenen Lotdepot, welches mit seiner freien Kontaktfläche Y zur Kontaktfläche A weisend mittels des Fixiermittels verbunden ist. Mit anderen Worten, es handelt sich um eine unverlötete Sandwichanordnung aus einem Bauelement mit einem mit seiner Kontaktfläche D verbundenen Lotdepot mit einer freien Kontaktfläche Y, die wiederum mittels des Fixiermittels mit der Kontaktfläche A des anderen Bauelements verbunden ist.

Eine weitere solche als Zwischenprodukt bei der ersten und dritten Ausführungsform des erfindungsgemäßen Verfahrens erhältliche Anordnung umfasst eine Anordnung aus einem Bauelement mit einer Kontaktfläche A und einer Lotvorform mit diskreten Kontaktflächen B und C mit dem Fixiermittel zwischen den Kontaktflächen A und B.

Eine weitere solche als Zwischenprodukt bei der zweiten und vierten Ausführungsform des erfindungsgemäßen Verfahrens erhältliche Anordnung umfasst eine Anordnung aus einem Bauelement mit einer Kontaktfläche D und einer Lotvorform mit diskreten Kontaktflächen B und C mit dem Fixiermittel zwischen den Kontaktflächen C und D.

Eine weitere solche als Zwischenprodukt bei der ersten bis vierten Ausführungsform des erfindungsgemäßen Verfahrens erhältliche Anordnung umfasst ein freies Bauelement mit einer mit dem Fixiermittel versehenen Kontaktfläche A respektive ein freies Bauelement mit einer mit dem Fixiermittel versehenen Kontaktfläche D.

Eine weitere solche als Zwischenprodukt bei der ersten bis vierten Ausführungsform des erfindungsgemäßen Verfahrens erhältliche Anordnung umfasst eine freie Lotvorform mit diskreten Kontaktflächen B und C, wobei die Kontaktflächen B und/oder C mit dem Fixiermittel versehen sind.

Im erfindungsgemäßen Verfahren werden die Kontaktflächen A zu B respektive C zu D gewandt angeordnet respektive in Kontakt gebracht. Dabei bilden die Kontaktflächen A und B respektive C und D jeweils miteinander eine gemeinsame Überlappungsfläche. Weisen die Kontaktflächen A und B respektive C und D nicht die gleichen Abmessungen auf oder sind die Kontaktflächen A und B respektive C und D bei der zueinander gewandten Anordnung nicht kongruent zueinander gewandt angeordnet, so entspricht die gemeinsame Überlappungsfläche einer Teilfläche mindestens einer der sie bildenden Kontaktflächen A und B respektive C und D. Betrachtet man die zu einander gewandte Anordnung und das Inkontaktbringen der Kontaktflächen A und Y respektive D und X, so gilt Analoges.

Hierin ist vom Inkontaktbringen von Kontaktflächen mit dem oder ohne das Fixiermittel zwischen den Kontaktflächen die Rede. In diesem Kontext bedeutet der Begriff "Kontakt" einen direkten Kontakt im Sinne einer Berührung bis hin zu einem Kontakt im Sinne einer Annäherung bis auf einen vernachlässigbaren Abstand von beispielsweise ≤100 µm. Letzteres trifft insbesondere zu im Falle eines Vorhandenseins des Fixiermittels zwischen Kontaktflächen. Zur Vermeidung von Missverständnissen, im Falle einer stoffschlüssigen Lotverbindung zwischen Kontaktflächen besteht lediglich eine indirekte Verbindung zwischen den lotverbundenen respektive verlöteten Kontaktflächen, hingegen ein direkter Kontakt zum verbindenden Lot. Das Inkontaktbringen von Kontaktflächen mit dem Fixiermittel zwischen besagten Kontaktflächen bedeutet, dass das Fixiermittel aus einer wie vorerwähnt zusammengesetzten Fixiermittelzusammensetzung auf mindestens eine der beiden beteiligten Kontaktflächen appliziert worden ist, was im Falle einer lösemittelhaltigen Fixiermittelzusammensetzung wie nacherwähnt ein Entfernen von Lösemittel vor dem eigentlichen Inkontaktbringen umfasst.

Die Kontaktflächen vom Typ A, B, C und D weisen eine nur geringe mittlere Oberflächenrauigkeit Ra (bestimmt nach DIN EN ISO 25178-6:2010-06) beispielsweise im Bereich von 0,1 bis 40 µm auf.

Im Allgemeinen sind die Kontaktflächen vom Typ A, B, C, D, X und Y eben oder im Wesentlichen eben.

Hierin wird der Ausdruck "Fixiermittel" oder "aus einer wie vorerwähnt zusammengesetzten Fixiermittelzusammensetzung appliziertes Fixiermittel" gebraucht. Gemeint ist damit das auf eine betreffende Kontaktfläche A, B, C, D, X respektive Y applizierte Fixiermittel in dem Zustand und unter den Bedingungen unmittelbar vor bzw. beim zueinander gewandten Anordnen und Inkontaktbringen der Kontaktflächen von Lotvorform und Bauelement mit dem Fixiermittel dazwischen respektive unmittelbar vor bzw. beim Fixieren des Lotdepots mit dem Fixiermittel zwischen den Kontaktflächen A und Y respektive D und X. Besagte Bedingungen umfassen beispielsweise die beim Anordnen und Inkontaktbringen herrschenden Bedingungen betreffend Temperatur, Luftdruck und Luftfeuchte respektive Temperatur und Art der Umgebungsatmosphäre. So kann es gegebenenfalls zweckmäßig sein, ein Anordnen und Inkontaktbringen bei erhöhter, in jedem Fall jedoch unterhalb der Schmelztemperatur des Lots liegender Temperatur durchzuführen. Beispielsweise kann dies mit erwärmten Kontaktflächen erfolgen.

Das Fixiermittel wird aus einer wie vorerwähnt zusammengesetzten Fixiermittelzusammensetzung appliziert.

Der hierin im Zusammenhang mit der Applikation von Fixiermittel aus einer wie vorerwähnt zusammengesetzten Fixiermittelzusammensetzung auf eine Kontaktfläche verwendete Begriff "Applizieren" kann eine sich gegebenenfalls währenddessen und/oder an das eigentliche Applizieren anschließende thermische und/oder photochemische Behandlung einschließen. Im Falle einer lösemittelhaltigen Fixiermittelzusammensetzung schließt der Begriff "Applizieren" in jedem Fall ein sich an das eigentliche Applizieren anschließendes Entfernen von Lösemittel, insbesondere weitgehendes bis bevorzugt vollständiges Entfernen von Lösemittel ein, beispielsweise durch Trocknen, was durch übliche Maßnahmen wie beispielsweise Erwärmen und/oder Druckverminderung unterstützt oder bewirkt werden kann. Weitgehende bis vollständige Lösemittelentfernung bedeutet Entfernung von >50 bis 100 Gew.-%, bevorzugt >80 bis 100 Gew.-% des ursprünglich in der lösemittelhaltigen Fixiermittelzusammensetzung enthaltenen Lösemittels.

Die Fixiermittelzusammensetzung besteht, wie schon gesagt, aus 0 bis 97 Gew.-% mindestens eines Lösemittels ausgewählt aus der Gruppe bestehend aus Wasser und bei ≤ 285°C siedenden organischen Lösemitteln, 3 bis 100 Gew.-% mindestens eines Materials M1 ausgewählt aus der Gruppe bestehend aus (i) im Bereich von 30 bis 180°C schmelzbaren thermoplastischen organischen Polymeren und (ii) im Bereich von 30 bis 180°C schmelzbaren nichtpolymeren organischen Verbindungen ohne saure Gruppen ausgewählt aus Lactamen und Fettalkoholen,
0 bis 20 Gew.-% mindestens eines Materials M2 ausgewählt aus der Gruppe bestehend aus (iii) im Bereich von 30 bis 180°C nicht schmelzbaren organischen Polymeren und (iv) im Bereich von 30 bis 180°C nicht schmelzbaren nichtpolymeren organischen Verbindungen ohne saure Gruppen und ohne Siedepunkt oder mit einem Siedepunkt oberhalb 285°C, und
0 bis 30 Gew.-% eines oder mehrerer anorganischer fester Füllstoffe.

Entsprechend ihres Gehaltes von 0 bis 97 Gew.-% mindestens eines Lösemittels ausgewählt aus der Gruppe bestehend aus Wasser und bei ≤ 285°C siedenden organischen Lösemitteln kann es sich bei der Fixiermittelzusammensetzung um eine lösemittelfreie, um eine wässrige von organischem Lösemittel freie, um eine wässrige organisches Lösemittel enthaltende oder um eine nichtwässrige organisches Lösemittel enthaltende Zusammensetzung handeln.

Beispiele für lösemittelfreie Fixiermittelzusammensetzungen sind beim Applizieren feste bis klebrige Fixiermittelzusammensetzungen, beispielsweise in Form von Folie, Strang, Pulver, Tropfen, Hotmelt-Material, öligem oder harzartigem Material. Abhängig von der Konsistenz einer betreffenden lösemittelfreien Fixiermittelzusammensetzung wird der Fachmann ein zum Applizieren auf eine Kontaktfläche A, B, C, D, X respektive Y geeignetes Verfahren auswählen.

Beispiele für wässrige Fixiermittelzusammensetzungen sind wässrige von organischem Lösemittel freie oder wässrige organisches Lösemittel enthaltende Fixiermittelzusammensetzungen. Dabei kann es sich um Lösungen, Suspensionen oder Dispersionen handeln, deren rheologisches Verhalten in einem breiten Bereich vom flüssigen bis zum pastösen Zustand liegen kann. Dementsprechend können die wässrigen Fixiermittelzusammensetzungen auf verschiedene Art auf eine Kontaktfläche A, B, C, D, X respektive Y appliziert werden, beispielsweise durch Jetten, Dispensen, Sprühen, Pinseln, Tupfen, Tauchen oder Drucken, gefolgt von einer Trocknung zwecks weitgehender bis bevorzugt vollständiger Entfernung des Wassers und des gegebenenfalls enthaltenen organischen Lösemittels.

Bei nichtwässrigen organisches Lösemittel enthaltenden Fixiermittelzusammensetzungen kann es sich um Lösungen, Suspensionen oder Dispersionen handeln, deren rheologisches Verhalten in einem breiten Bereich vom flüssigen bis zum pastösen Zustand liegen kann. Dementsprechend können die nichtwässrigen organisches Lösemittel enthaltenden Fixiermittelzusammensetzungen auf verschiedene Art auf eine Kontaktfläche A, B, C, D, X respektive Y appliziert werden, beispielsweise durch Jetten, Dispensen, Sprühen, Pinseln, Tupfen, Tauchen oder Drucken, gefolgt von einer Trocknung zwecks weitgehender bis bevorzugt vollständiger Entfernung des organischen Lösemittels.

Bevorzugt als das mindestens eine Material M1 sind im Bereich von 30 bis 180°C schmelzbare thermoplastische organische Polymere vom Typ (i), und darunter insbesondere teil- oder vollsynthetische Vertreter. Bevorzugt umfasst das mindestens eine Material M1 keine nichtsynthetischen organischen Polymere, d.h. keine organischen Polymere natürlichen Ursprungs wie Naturharze. Beispiele für Naturharze sind Baumharze wie Kolophoniumharz. Stofflich besteht für die im Bereich von 30 bis 180°C schmelzbaren thermoplastischen organischen Polymere keine Beschränkung. Es kann sich beispielsweise um Vinylcopolymere, (Meth)acrylcopolymere, Polyester, Polyurethane, Polymervorläufer solcher vorerwähnten Polymere und/oder um Cellulosederivate wie beispielsweise Celluloseether und -ester handeln. Besonders bevorzugt sind (Meth)acrylcopolymere und Cellulosederivate wie Methylcellulose oder Ethylcellulose. Die im Bereich von 30 bis 180°C schmelzbaren thermoplastischen organischen Polymere können saure Gruppen entsprechend einer Säurezahl im Bereich von 0 bis 50 mg KOH/g, bevorzugt unter 25 mg KOH/g aufweisen; besonders bevorzugt haben sie keine sauren Gruppen und weisen keine Säurezahl auf. Die Bestimmung der Säurezahl, beispielsweise Carboxylzahl von organischen Polymeren ist dem Fachmann bekannt, beispielsweise die Bestimmung nach DIN EN ISO 2114.

Bevorzugte Beispiele für im Bereich von 30 bis 180°C schmelzbare nichtpolymere organische Verbindungen ohne saure Gruppen vom Typ (ii) sind Lactame wie beispielsweise Laurinlactam; und Fettalkohole wie beispielsweise 1-Dodecanol (Laurylalkohol), 1-Tetradecanol (Myristylalkohol), 1-Hexadecanol (Cetylalkohol), 1-Heptadecanol (Margarylalkohol), 1-Octadecanol (Stearylalkohol), 1-Eicosanol (Arachidylalkohol), 1-Docosanol (Behenylalkohol), 1-Tetracosanol (Lignocerylalkohol), 1-Hexacosanol (Cerylalkohol), 1-Octacosanol (Montanylalkohol), 1-Triacontanol (Melissylalkohol).

Die Fixiermittelzusammensetzung enthält 0 bis 20 Gew.-% mindestens eines Materials M2 ausgewählt aus der Gruppe bestehend aus (iii) im Bereich von 30 bis 180°C nicht schmelzbaren organischen Polymeren und (iv) im Bereich von 30 bis 180°C nicht schmelzbaren nichtpolymeren organischen Verbindungen ohne saure Gruppen und ohne Siedepunkt oder mit einem Siedepunkt oberhalb 285°C. Die organischen Polymere vom Typ (iii) unterscheiden sich von denen vom Typ (i) und besitzen bevorzugt auch keine sauren Gruppen. Beispielsweise kann es sich um nichtthermoplastische oder um außerhalb des Bereichs von 30 bis 180 °C schmelzbare organische Polymere handeln. Die nichtpolymeren organischen Verbindungen vom Typ (iv) unterscheiden sich von denen vom Typ (ii); beispielsweise kann es sich um außerhalb des Bereichs von 30 bis 180 °C schmelzbare nichtpolymere organische Verbindungen ohne saure Gruppen handeln; alternativ kann es sich um nichtpolymere organische Verbindungen ohne saure Gruppen handeln, die unzersetzt oberhalb 285°C sieden und destilliert werden können oder die anstelle eines Siedepunktes einen Zersetzungspunkt oder -bereich aufweisen. Letztere lassen sich nicht unter Normalbedingungen destillieren.

Bei Vertretern des Materials M2 kann es sich beispielsweise um Additive wie beispielsweise Benetzungsadditive und Rheologieadditive handeln.

Die Fixiermittelzusammensetzung enthält 0 bis 30 Gew.-% eines oder mehrerer anorganischer fester Füllstoffe. Beispiele für anorganische feste Füllstoffe sind Siliziumdioxid und Aluminiumoxid.

Die Summe der mit dem Fixiermittel versehenen Flächenanteile der miteinander eine gemeinsame Überlappungsfläche bildenden Kontaktflächen A und B respektive C und D beträgt 1500 µm² bis 50 Flächen-%, bevorzugt 1500 µm² bis 20 Flächen-%, insbesondere 1500 µm² bis 10 Flächen-% der gemeinsamen Überlappungsfläche.

Gleiches gilt beim eventuellen Fixieren der freien Kontaktfläche X respektive Y des Lotdepots; dabei kann die Summe der mit aus der Fixiermittelzusammensetzung appliziertem Fixiermittel versehenen Flächenanteile der miteinander eine gemeinsame Überlappungsfläche bildenden Kontaktflächen A und Y respektive D und X bei Anwesenheit eines oder mehrerer Bestandteile vom Typ (i) im mindestens einen Material M1 1500 µm² bis 50 Flächen-%, bevorzugt 1500 µm² bis 20 Flächen-%, insbesondere 1500 µm² bis 10 Flächen-% der gemeinsamen Überlappungsfläche betragen. Bei alleiniger Anwesenheit eines oder mehrerer Bestandteile vom Typ (ii) im mindestens einen Material M1 beträgt besagte Summe 1500 µm² bis 100 Flächen-%, bevorzugt 1500 µm² bis 50 Flächen-%, insbesondere 1500 µm² bis 20 Flächen-% oder sogar nur 1500 µm² bis 10 Flächen-% der gemeinsamen Überlappungsfläche.

Das Fixiermittel kann dabei in allen vorerwähnten Fällen als einzelne zusammenhängende Fläche oder als mehrere voneinander getrennte Flächen verteilt vorliegen, beispielsweise als ein oder mehrere Flächenelemente, beispielsweise als Punkte, Linien, Linien- oder Punktemuster. Einzelne der oder alle Flächenelemente können auch über eine betreffende Überlappungsflächenbegrenzungslinie hinausragen, beispielsweise dergestalt, dass die Fixiermittelzusammensetzung absichtlich oder unabsichtlich eine betreffende Überlappungsflächenbegrenzungslinie überschreitend appliziert wird. Beispielsweise kann ein Flächenelement die Überlappungsflächenbegrenzungslinie teilweise bedecken und sich dabei teilweise innerhalb und teilweise außerhalb der Überlappungsfläche befinden. Auch eine teilweise oder vollständige rahmenartige Bedeckung der Überlappungsflächenbegrenzungslinie ist möglich. Einzelne zusammenhängende die Überlappungsflächenbegrenzungslinie nicht berührende Flächenelemente können eine Fläche von beispielsweise 1500 µm² bis 10 Flächen-%, bevorzugt 1500 µm² bis 5 Flächen-%, insbesondere 1500 µm² bis 2 Flächen-% der betreffenden gemeinsamen Überlappungsfläche haben. Das oder die Flächenelemente können aus der entsprechenden Kontaktflächenebene hinreichend weit herausragen, um eine Fixierverbindung zu verbindender Kontaktflächen zu ermöglichen. So können das oder die aus dem Fixiermittel bestehenden Flächenelemente eine Dicke beispielsweise im Bereich von 1 bis 100 µm oder bevorzugt 1 bis 50 µm oder mehr bevorzugt 1 bis 20 µm oder am meisten bevorzugt 1 bis 10 µm aufweisen; dies gilt insbesondere für nicht oder nicht vollständig geschmolzenes Fixiermittel.

Das applizierte Fixiermittel kann sich in seiner Zusammensetzung qualitativ und/oder quantitativ von der der Fixiermittelzusammensetzung unterscheiden. Dies kann beispielsweise Folge seiner Applikation und/oder einer im Rahmen seiner Applikation bewusst durchgeführten Entfernung von Lösemittel oder Trocknung und/oder thermischen und/oder photochemischen Behandlung sein. Im Falle eines aus einer Lösemittel enthaltenden Fixiermittelzusammensetzung applizierten Fixiermittels ist dessen Lösemittelanteil relativ zu dem der Fixiermittelzusammensetzung um >50 bis 100 Gew.-%, bevorzugt um >80 bis 100 Gew.-% reduziert. Mit anderen Worten, im Vergleich zur lösemittelhaltigen Fixiermittelzusammensetzung ist im applizierten Fixiermittel mehr als die Hälfte, bevorzugt mehr als 80 Gew.-% des ursprünglich in der lösemittelhaltigen Fixiermittelzusammensetzung enthaltenen Lösemittels entfernt.

Ein sich in seiner Zusammensetzung von der vorerwähnten Fixiermittelzusammensetzung unterscheidendes Fixiermittel kann beispielsweise aus 0 bis 10 Gew.-% mindestens eines Lösemittels ausgewählt aus der Gruppe bestehend aus Wasser und bei ≤ 285°C siedenden organischen Lösemitteln, 65 bis 100 Gew.-% mindestens eines Materials M1 ausgewählt aus der Gruppe bestehend aus (i) im Bereich von 30 bis 180°C schmelzbaren thermoplastischen organischen Polymeren und (ii) im Bereich von 30 bis 180°C schmelzbaren nichtpolymeren organischen Verbindungen ohne saure Gruppen,
0 bis 25 Gew.-% mindestens eines Materials M2 ausgewählt aus der Gruppe bestehend aus (iii) im Bereich von 30 bis 180°C nicht schmelzbaren organischen Polymeren und (iv) im Bereich von 30 bis 180°C nicht schmelzbaren nichtpolymeren organischen Verbindungen ohne saure Gruppen und ohne Siedepunkt oder mit einem Siedepunkt oberhalb 285°C, und
0 bis 35 Gew.-% eines oder mehrerer anorganischer fester Füllstoffe bestehen.

Das Fixiermittel zeigt ein haftvermittelndes Verhalten zwischen zu verbindenden Kontaktflächen A und B, C und D, A und Y respektive D und X, d.h. zumindest bei den beim Anordnen und Inkontaktbringen der betreffenden Kontaktflächen mit dem dazwischen befindlichen Fixiermittel herrschenden Bedingungen verhält es sich klebrig und/oder Adhäsion der betreffenden Kontaktflächen bewirkend.

Die vorerwähnten vier Ausführungsformen des erfindungsgemäßen Verfahrens umfassen jeweils ein Platzieren der Lotvorform, beispielsweise ein Auflegen der Lotvorform auf ein Bauelement oder umgekehrt. Das Auflegen geschieht dabei im Sinne einer zueinander gewandten Anordnung der Kontaktflächen A und B respektive C und D.

Platzieren der Lotvorform und Herstellen des Lotdepots als auch das nachgeschaltete Herstellen der noch unverlöteten Sandwichanordnung kann beispielsweise im Bereich von Raumtemperatur bis unterhalb der Schmelztemperatur des Lots stattfinden, beispielsweise bis 10 °C unterhalb der Schmelztemperatur des Lots.

Nach dem Platzieren der Lotvorform findet die Herstellung des Lotdepots statt. Dies umfasst das Schmelzen der Lotvorform unter Bildung geschmolzenen Lots und ein anschließendes Abkühlen des geschmolzenen Lots unter dessen Erstarrungstemperatur.

Die Anordnung aus Bauelement und Lotvorform mit dem Fixiermittel zwischen den Kontaktflächen A und B respektive C und D wird zwecks Schmelzen der Lotvorform in einen Ofen mit einer oberhalb der Schmelztemperatur des Lots liegenden Ofentemperatur befördert. Die Aufenthaltsdauer im Ofen und die Ofentemperatur sind so bemessen, dass ein vollständiges Schmelzen der Lotvorform stattfinden kann. Beispielsweise beträgt die Aufenthaltsdauer im Ofen im Bereich von 1 bis 60 Minuten bei einer Ofentemperatur beispielsweise im Bereich von 150 bis 500°C, insbesondere 170 bis 350°C. Der Schmelzprozess kann als Batch- oder als kontinuierlicher Prozess durchgeführt werden.

Es ist nicht im Einzelnen geklärt, was beim Schmelzvorgang mit dem Fixiermittel geschieht.

Nach Verlassen des Ofens kühlt die Anordnung aus Bauelement und dem geschmolzenem Lot ab und das Lot erstarrt nach Unterschreiten seiner Erstarrungstemperatur unter Bildung des mit dem Lotdepot ausgestatteten Bauelements. Im Falle eines Bauelements mit einer Kontaktfläche A hat das Lotdepot eine freie Kontaktfläche X, im Falle eines Bauelements mit einer Kontaktfläche D hat das Lotdepot eine freie Kontaktfläche Y.

Den vorerwähnten vier Ausführungsformen des erfindungsgemäßen Verfahrens gemein ist die Herstellung einer noch unverlöteten Sandwichanordnung aus den beiden Bauelementen mit dem dazwischen befindlichen Lotdepot gegebenenfalls mit dem Fixiermittel zwischen den Kontaktflächen A und Y respektive D und X, gefolgt vom eigentlichen Verlöten unter Bildung der fertigen verlöteten Sandwichanordnung.

Durch zur Kontaktfläche A respektive D weisendes Anordnen der Kontaktfläche Y respektive X, gegebenenfalls mit dem dazwischen befindlichen Fixiermittel, wird die unverlötete Sandwichanordnung aus mit Lotdepot versehenem Bauelement und über die freie Kontaktfläche des Lotdepots damit zu verbindendem weiteren Bauelement geschaffen.

Nach Bildung der noch unverlöteten Sandwichanordnung findet der eigentliche Lötverbindungsprozess statt. Dieser Lötverbindungsprozess umfasst das Schmelzen des Lotdepots unter Bildung geschmolzenen Lots und ein anschließendes Abkühlen des geschmolzenen Lots unter dessen Erstarrungstemperatur unter Bildung einer fertigen verlöteten Sandwichanordnung aus den beiden über ihre Kontaktflächen A und D und das dazwischen befindliche erstarrte Lot verbundenen Bauelementen.

Die Sandwichanordnung aus den beiden Bauelementen mit dem dazwischen befindlichen Lotdepot gegebenenfalls mit dem Fixiermittel zwischen den Kontaktflächen A und Y respektive D und X wird zwecks Schmelzen des Lotdepots in einen Ofen mit einer oberhalb der Schmelztemperatur des Lots liegenden Ofentemperatur befördert. Die Aufenthaltsdauer im Ofen und die Ofentemperatur sind so bemessen, dass ein vollständiges Schmelzen des Lotdepots stattfinden kann. Beispielsweise beträgt die Aufenthaltsdauer im Bereich von 1 bis 60 Minuten bei einer Ofentemperatur beispielsweise im Bereich von 150 bis 500°C, insbesondere 170 bis 350°C. Der Schmelzprozess kann als Batch- oder als kontinuierlicher Prozess durchgeführt werden.

Es ist nicht im Einzelnen geklärt, was beim Schmelzvorgang bzw. Lötprozess mit dem gegebenenfalls vorhandenen Fixiermittel geschieht.

Nach Verlassen des Ofens kühlt die Sandwichanordnung aus den beiden Bauelementen und dem geschmolzenem Lot ab und das Lot erstarrt nach Unterschreiten seiner Erstarrungstemperatur unter Bildung des Produkts des erfindungsgemäßen Verfahrens, nämlich der fertigen Sandwichanordnung aus dem ersten Bauelement mit der Kontaktfläche A, dem zweiten Bauelement mit der Kontaktfläche D mit dem zwischen den Kontaktflächen A und D befindlichen die beiden Bauelemente mechanisch, elektrisch und wärmeleitend verbindenden Lot.

### Beispiele

### Beispiel 1 (erfindungsgemäß):

Eine Fixiermittelzusammensetzung bestehend aus 20 Gew.-% DEGALAN^{®} LP 63/11 (Acrylcopolymer erhältlich von Evonik Industries AG, Säurezahl 6 mg KOH/g, Mw 30.000) gelöst in 80 Gew.-% α-Terpineo! wurde mittels einer 20 µm dicken Schablone mit einer runden Öffnung und einem Durchmesser von 40 µm auf eine Kupferseite eines DCB-Substrats (320 µm dicke Al₂O₃-Keramik mit beidseitiger jeweils 200 µm Kupferkaschierung) gedruckt. Anschließend wurde die so applizierte Fixiermittelzusammensetzung 20 min lang bei 80°C im Umlufttrockenschrank getrocknet. Man erhielt einen 2000 µm² großen und 3 µm dicken Fixiermittelpunkt. Auf diesen Fixiermittelpunkt wurde anschließend eine 10 mm × 10 mm × 0,1 mm große Lotvorform (Zinn-Silber-Legierung mit 3,5 Gew.-% Silberanteil) maschinell zentrisch platziert. Dies geschah mittels einer Bestückungsapparatur Datacon 2200 evo, wobei das DCB-Substrat vor dem eigentlichen Bestücken auf 130°C vorgewärmt und die Lotvorform mit einer Kraft von 1 Newton auf den Fixiermittelpunkt aufgelegt wurde.

Die so geschaffene Anordnung wurde in einem Lötofen einem Temperaturprofil von 6 Minuten bei 180°C und anschließend 3 Minuten bei 260°C ausgesetzt. Nach Entnahme aus dem Ofen wurde die Anordnung auf Raumtemperatur abkühlen gelassen. Aus der Lotvorform hatte sich ein mit der Kupferseite der DCB fest verbundenes Lotdepot gebildet.

In einem weiteren Schritt wurde das Drucken und Trocknen der Fixiermittelzusammensetzung analog wie zuvor beschrieben auf der nach außen weisenden Seite des Lotdepots wiederholt. Auf den so auf das Lotdepot applizierten Fixiermittelpunkt wurde anschließend ein 10 mm x 10 mm x 0,18 mm großer IGBT unter den gleichen Bedingungen und unter Verwendung der gleichen Bestückungsapparatur platziert.

Die so geschaffene noch unverlötete Sandwichanordnung wurde in einem Lötofen einem Temperaturprofil von 6 Minuten bei 180°C und anschließend 3 Minuten bei 260°C ausgesetzt, wobei das Lot vollständig schmolz. Nach Entnahme aus dem Ofen wurde die Sandwichanordnung auf Raumtemperatur abkühlen gelassen.

Nach dem Abkühlen wurde die Wärmeleitfähigkeit der Lotverbindung innerhalb der Sandwichanordnung mittels der Laserflashmethode (Gerät LFA 467 der Firma Netzsch, Deutschland, Energieimpuls von der Seite des IGBT her) zu 36 Wm⁻¹K⁻¹ bestimmt.

### Beispiel 2 (erfindungsgemäß):

Abweichend von Beispiel 1 wurde die Fixiermittelzusammensetzung jeweils mittels einer 20 µm dicken Schablone mit vier als 2·2-Anordnung mit jeweils 2 mm voneinander beabstandeten quadratischen Öffnungen von jeweils 9 mm² gedruckt. Man erhielt vier jeweils circa 10 mm² große und 3 µm dicke Fixiermittel-Flächenelemente (insgesamt circa 40 Flächen-% Bedeckung der jeweiligen Überlappungsfläche nach Auflegen der Lotvorform bzw. nach dem Bestücken mit dem IGBT).

Die Wärmeleitfähigkeitsbestimmung ergab einen Wert von 22 Wm⁻¹K⁻¹.

### Beispiel 3 (Vergleich):

Abweichend von Beispiel 1 wurde die Fixiermittelzusammensetzung jeweils mittels einer 20 µm dicken Schablone mit vier als 2·2-Anordnung mit jeweils 2 mm voneinander beabstandeten quadratischen Öffnungen von jeweils 13 mm² gedruckt. Man erhielt vier jeweils circa 13,5 mm² große und 3 µm dicke Fixiermittel-Flächenelemente (insgesamt circa 55 Flächen-% Bedeckung der jeweiligen Überlappungsfläche nach Auflegen der Lotvorform bzw. nach dem Bestücken mit dem IGBT).

Die Wärmeleitfähigkeitsbestimmung ergab einen Wert von 15 Wm⁻¹K⁻¹.

Wärmeleitfähigkeiten >20 Wm⁻¹K⁻¹ stellen zufriedenstellende Ergebnisse dar.

## Patentansprüche

1. Verfahren zur Herstellung einer Sandwichanordnung aus einem ersten Bauelement mit einer Kontaktfläche A, einem zweiten Bauelement mit einer Kontaktfläche D und zwischen den Kontaktflächen A und D befindlichem Lot, wobei das Lot durch Schmelzen eines zwischen den beiden Bauelementen angeordneten und an der Kontaktfläche A oder D mit einem der Bauelemente verbundenen Lotdepots und anschließendes Abkühlen des geschmolzenen Lots unter seine Erstarrungstemperatur hergestellt wird,
wobei das Lotdepot zuvor durch Schmelzen einer mittels eines aus einer Fixiermittelzusammensetzung applizierten Fixiermittels an der betreffenden Kontaktfläche A oder D fixierten Lotvorform und anschließendes Abkühlen des geschmolzenen Lots unter seine Erstarrungstemperatur hergestellt wird, und wobei das Lotdepot mit seiner freien Kontaktfläche zur entsprechenden Kontaktfläche D respektive A des noch unverbundenen Bauelements gewandt angeordnet ist,
wobei die Fixiermittelzusammensetzung aus
0 bis 97 Gew.-% mindestens eines Lösemittels ausgewählt aus der Gruppe bestehend aus Wasser und bei ≤ 285°C siedenden organischen Lösemitteln,
3 bis 100 Gew.-% mindestens eines Materials M1 ausgewählt aus der Gruppe bestehend aus (i) im Bereich von 30 bis 180°C schmelzbaren thermoplastischen organischen Polymeren und (ii) im Bereich von 30 bis 180°C schmelzbaren nichtpolymeren organischen Verbindungen ohne saure Gruppen ausgewählt aus Lactamen und Fettalkoholen,
0 bis 20 Gew.-% mindestens eines Materials M2 ausgewählt aus der Gruppe bestehend aus (iii) im Bereich von 30 bis 180°C nicht schmelzbaren organischen Polymeren und (iv) im Bereich von 30 bis 180°C nicht schmelzbaren nichtpolymeren organischen Verbindungen ohne saure Gruppen und ohne Siedepunkt oder mit einem Siedepunkt oberhalb 285°C, und
0 bis 30 Gew.-% eines oder mehrerer anorganischer fester Füllstoffe besteht, und wobei die Summe der mit dem Fixiermittel versehenen Flächenanteile der beim Platzieren der Lotvorform miteinander eine gemeinsame Überlappungsfläche bildenden Kontaktflächen A und B respektive C und D 1500 µm² bis 50 Flächen-% der gemeinsamen Überlappungsfläche beträgt.

2. Verfahren nach Anspruch 1, umfassend die aufeinander folgenden Schritte:
(1) Bereitstellen eines ersten Bauelements mit einer Kontaktfläche A, eines zweiten Bauelements mit einer Kontaktfläche D, der Fixiermittelzusammensetzung sowie einer Lotvorform mit diskreten jeweils nicht mit Fixiermittel versehenen Kontaktflächen B und C,
(2) Applizieren des Fixiermittels aus der Fixiermittelzusammensetzung auf die Kontaktflächen A und/oder B,
(3) Platzieren der Lotvorform mit ihrer Kontaktfläche B auf die Kontaktfläche A mit dem Fixiermittel zwischen den Kontaktflächen A und B,
(4) Schmelzen der fixierten Lotvorform unter Bildung geschmolzenen Lots,
(5) Abkühlen des geschmolzenen Lots unter seine Erstarrungstemperatur unter Bildung eines Lotdepots mit einer freien Kontaktfläche X,
(6) gegebenenfalls Applizieren des Fixiermittels aus der Fixiermittelzusammensetzung auf die Kontaktflächen D und/oder X,
(7) Herstellen einer Sandwichanordnung aus den beiden Bauelementen mit dem dazwischen befindlichen Lotdepot durch Anordnen der Kontaktflächen X und D in zueinander gewandter Position mit dem gegebenenfalls dazwischen befindlichen Fixiermittel,
(8) Schmelzen des Lotdepots unter Bildung geschmolzenen Lots, und
(9) Abkühlen des geschmolzenen Lots unter seine Erstarrungstemperatur unter Bildung einer Sandwichanordnung aus den beiden über ihre Kontaktflächen A und D und das dazwischen befindliche erstarrte Lot verbundenen Bauelementen.

3. Verfahren nach Anspruch 1, umfassend die aufeinander folgenden Schritte
(1) Bereitstellen eines ersten Bauelements mit einer Kontaktfläche A, eines zweiten Bauelements mit einer Kontaktfläche D, der Fixiermittelzusammensetzung sowie einer Lotvorform mit diskreten jeweils nicht mit Fixiermittel versehenen Kontaktflächen B und C,
(2) Applizieren des Fixiermittels aus der Fixiermittelzusammensetzung auf die Kontaktflächen C und/oder D,
(3) Platzieren der Lotvorform mit ihrer Kontaktfläche C auf die Kontaktfläche D mit dem Fixiermittel zwischen den Kontaktflächen C und D,
(4) Schmelzen der fixierten Lotvorform unter Bildung geschmolzenen Lots,
(5) Abkühlen des geschmolzenen Lots unter seine Erstarrungstemperatur unter Bildung eines Lotdepots mit einer freien Kontaktfläche Y,
(6) gegebenenfalls Applizieren des Fixiermittels aus der Fixiermittelzusammensetzung auf die Kontaktflächen A und/oder Y,
(7) Herstellen einer Sandwichanordnung aus den beiden Bauelementen mit dem dazwischen befindlichen Lotdepot durch Anordnen der Kontaktflächen Y und A in zueinander gewandter Position mit dem gegebenenfalls dazwischen befindlichen Fixiermittel,
(8) Schmelzen des Lotdepots unter Bildung geschmolzenen Lots, und
(9) Abkühlen des geschmolzenen Lots unter seine Erstarrungstemperatur unter Bildung einer Sandwichanordnung aus den beiden über ihre Kontaktflächen A und D und das dazwischen befindliche erstarrte Lot verbundenen Bauelementen.

4. Verfahren nach Anspruch 1, umfassend die aufeinander folgenden Schritte:
(1) Bereitstellen eines ersten Bauelements mit einer Kontaktfläche A, eines zweiten Bauelements mit einer Kontaktfläche D, einer Lotvorform mit diskreten Kontaktflächen B und C, wovon nur die Kontaktfläche B mit dem Fixiermittel versehen ist, sowie gegebenenfalls der Fixiermittelzusammensetzung,
(2) gegebenenfalls Applizieren des Fixiermittels aus der Fixiermittelzusammensetzung auf die Kontaktfläche A,
(3) Platzieren der Lotvorform mit ihrer Kontaktfläche B auf die Kontaktfläche A mit dem Fixiermittel zwischen den Kontaktflächen A und B,
(4) Schmelzen der fixierten Lotvorform unter Bildung geschmolzenen Lots,
(5) Abkühlen des geschmolzenen Lots unter seine Erstarrungstemperatur unter Bildung eines Lotdepots mit einer freien Kontaktfläche X,
(6) gegebenenfalls Applizieren des Fixiermittels aus der Fixiermittelzusammensetzung auf die Kontaktflächen D und/oder X,
(7) Herstellen einer Sandwichanordnung aus den beiden Bauelementen mit dem dazwischen befindlichen Lotdepot durch Anordnen der Kontaktflächen X und D in zueinander gewandter Position mit dem gegebenenfalls dazwischen befindlichen Fixiermittel,
(8) Schmelzen des Lotdepots unter Bildung geschmolzenen Lots, und
(9) Abkühlen des geschmolzenen Lots unter seine Erstarrungstemperatur unter Bildung einer Sandwichanordnung aus den beiden über ihre Kontaktflächen A und D und das dazwischen befindliche erstarrte Lot verbundenen Bauelementen.

5. Verfahren nach Anspruch 1, umfassend die aufeinander folgenden Schritte:
(1) Bereitstellen eines ersten Bauelements mit einer Kontaktfläche A, eines zweiten Bauelements mit einer Kontaktfläche D, einer Lotvorform mit diskreten Kontaktflächen B und C, wovon nur die Kontaktfläche C mit dem Fixiermittel versehen ist, sowie gegebenenfalls der Fixiermittelzusammensetzung,
(2) gegebenenfalls Applizieren des Fixiermittels aus der Fixiermittelzusammensetzung auf die Kontaktfläche D,
(3) Platzieren der Lotvorform mit ihrer Kontaktfläche C auf die Kontaktfläche D mit dem Fixiermittel zwischen den Kontaktflächen C und D,
(4) Schmelzen der fixierten Lotvorform unter Bildung geschmolzenen Lots,
(5) Abkühlen des geschmolzenen Lots unter seine Erstarrungstemperatur unter Bildung eines Lotdepots mit einer freien Kontaktfläche Y,
(6) gegebenenfalls Applizieren des Fixiermittels aus der Fixiermittelzusammensetzung auf die Kontaktflächen A und/oder Y,
(7) Herstellen einer Sandwichanordnung aus den beiden Bauelementen mit dem dazwischen befindlichen Lotdepot durch Anordnen der Kontaktflächen Y und A in zueinander gewandter Position mit dem gegebenenfalls dazwischen befindlichen Fixiermittel,
(8) Schmelzen des Lotdepots unter Bildung geschmolzenen Lots, und
(9) Abkühlen des geschmolzenen Lots unter seine Erstarrungstemperatur unter Bildung einer Sandwichanordnung aus den beiden über ihre Kontaktflächen A und D und das dazwischen befindliche erstarrte Lot verbundenen Bauelementen.

6. Zwischenprodukt des Verfahrens nach Anspruch 2 oder 4 in Form einer Anordnung aus einem ersten Bauelement mit einer Kontaktfläche A und einem zweiten Bauelement mit einer Kontaktfläche D und einem zwischen den Kontaktflächen A und D angeordneten mit der Kontaktfläche A verbundenen Lotdepot, welches mit seiner freien Kontaktfläche X zur Kontaktfläche D weisend mittels des aus der Fixiermittelzusammensetzung applizierten Fixiermittels verbunden ist, oder nach Anspruch 3 oder 5 in Form einer
Anordnung aus einem ersten Bauelement mit einer Kontaktfläche A und einem zweiten Bauelement mit einer Kontaktfläche D und einem zwischen den Kontaktflächen A und D angeordneten mit der Kontaktfläche D verbundenen Lotdepot, welches mit seiner freien Kontaktfläche Y zur Kontaktfläche A weisend mittels des aus der Fixiermittelzusammensetzung applizierten Fixiermittels verbunden ist.

## Claims

1. A method for producing a sandwich arrangement consisting of a first component comprising a contact surface A, a second component comprising a contact surface D, and solder located between the contact surfaces A and D,
wherein the solder is produced by melting a solder deposit that is arranged between the two components and that is connected to one of the components at the contact surface A or D, followed by cooling the molten solder below its solidification temperature,
wherein the solder deposit is produced previously by melting a solder preform that is fixed to the relevant contact surface A or D by means of a fixing agent applied from a fixing agent composition, followed by cooling the molten solder below its solidification temperature, and
wherein the solder deposit is arranged so as to have its free contact surface facing the corresponding contact surface D or A, respectively, of the as of yet unconnected component, wherein the fixing agent composition consists of
0 to 97 wt.% of at least one solvent selected from the group consisting of water and organic solvents boiling at ≤ 285 °C,
3 to 100 wt.% of at least one material M1 selected from the group consisting of (i) thermoplastic organic polymers that are meltable in the range of 30 to 180 °C and (ii) non-polymeric organic compounds that are meltable in the range of 30 to 180 °C, do not have acidic groups and are selected from lactams and fatty alcohols,
0 to 20 wt.% of at least one material M2 selected from the group consisting of (iii) organic polymers that are not meltable in the range of 30 to 180 °C and (iv) non-polymeric organic compounds that are not meltable in the range of 30 to 180 °C, do not have acidic groups and do not have a boiling point or have a boiling point above 285 °C, and
0 to 30 wt.% of one or more inorganic solid fillers, and
wherein the sum of the surface portions provided with the fixing agent, of the contact surfaces A and B or C and D, respectively, which contact surfaces together form a common overlapping area upon placement of the solder preform, is 1500 µm² to 50 % by area of the common overlapping area.

2. The method according to claim 1, comprising the sequential steps of:
(1) providing a first component comprising a contact surface A, a second component comprising a contact surface D, the fixing agent composition, and a solder preform comprising discrete contact surfaces B and C that are not provided with fixing agent,
(2) applying the fixing agent from the fixing agent composition to the contact surfaces A and/or B,
(3) placing the solder preform by its contact surface B onto the contact surface A with the fixing agent between the contact surfaces A and B,
(4) melting the fixed solder preform to form molten solder,
(5) cooling the molten solder below its solidification temperature to form a solder deposit comprising a free contact surface X,
(6) optionally applying the fixing agent from the fixing agent composition to the contact surfaces D and/or X,
(7) producing a sandwich arrangement consisting of the two components with the solder deposit located therebetween by arranging the contact surfaces X and D in a position in which they face each other with the fixing agent optionally located therebetween,
(8) melting the solder deposit to form molten solder, and
(9) cooling the molten solder below its solidification temperature to form a sandwich arrangement consisting of the two components connected via their contact surfaces A and D and the solidified solder located therebetween.

3. The method according to claim 1, comprising the sequential steps of
(1) providing a first component comprising a contact surface A, a second component comprising a contact surface D, the fixing agent composition, and a solder preform comprising discrete contact surfaces B and C that are not provided with fixing agent,
(2) applying the fixing agent from the fixing agent composition to the contact surfaces C and/or D,
(3) placing the solder preform by its contact surface C onto the contact surface D with the fixing agent between the contact surfaces C and D,
(4) melting the fixed solder preform to form molten solder,
(5) cooling the molten solder below its solidification temperature to form a solder deposit comprising a free contact surface Y,
(6) optionally applying the fixing agent from the fixing agent composition to the contact surfaces A and/or Y,
(7) producing a sandwich arrangement consisting of the two components with the solder deposit located therebetween by arranging the contact surfaces Y and A in a position in which they face one another with the fixing agent optionally located therebetween,
(8) melting the solder deposit to form molten solder, and
(9) cooling the molten solder below its solidification temperature to form a sandwich arrangement consisting of the two components connected via their contact surfaces A and D and the solidified solder located therebetween.

4. The method according to claim 1, comprising the sequential steps of:
(1) providing a first component comprising a contact surface A, a second component comprising a contact surface D, a solder preform comprising discrete contact surfaces B and C, of which only the contact surface B is provided with the fixing agent, and optionally the fixing agent composition,
(2) optionally applying the fixing agent from the fixing agent composition to the contact surface A,
(3) placing the solder preform by its contact surface B onto the contact surface A with the fixing agent between the contact surfaces A and B,
(4) melting the fixed solder preform to form molten solder,
(5) cooling the molten solder below its solidification temperature to form a solder deposit comprising a free contact surface X,
(6) optionally applying the fixing agent from the fixing agent composition to the contact surfaces D and/or X,
(7) producing a sandwich arrangement consisting of the two components with the solder deposit located therebetween by arranging the contact surfaces X and D in a position in which they face each other with the fixing agent optionally located therebetween,
(8) melting the solder deposit to form molten solder, and
(9) cooling the molten solder below its solidification temperature to form a sandwich arrangement consisting of the two components connected via their contact surfaces A and D and the solidified solder located therebetween.

5. The method according to claim 1, comprising the sequential steps of:
(1) providing a first component comprising a contact surface A, a second component comprising a contact surface D, a solder preform comprising discrete contact surfaces B and C, of which only the contact surface C is provided with the fixing agent, and optionally the fixing agent composition,
(2) optionally applying the fixing agent from the fixing agent composition to the contact surface D,
(3) placing the solder preform by its contact surface C onto the contact surface D with the fixing agent between the contact surfaces C and D,
(4) melting the fixed solder preform to form molten solder,
(5) cooling the molten solder below its solidification temperature to form a solder deposit comprising a free contact surface Y,
(6) optionally applying the fixing agent from the fixing agent composition to the contact surfaces A and/or Y,
(7) producing a sandwich arrangement consisting of the two components with the solder deposit located therebetween by arranging the contact surfaces Y and A in a position in which they face one another with the fixing agent optionally located therebetween,
(8) melting the solder deposit to form molten solder, and
(9) cooling the molten solder below its solidification temperature to form a sandwich arrangement consisting of the two components connected via their contact surfaces A and D and the solidified solder located therebetween.

6. An intermediate product of the method according to claim 2 or 4 in the form of an arrangement consisting of a first component comprising a contact surface A and a second component comprising a contact surface D and a solder deposit that is arranged between the contact surfaces A and D and that is connected to the contact surface A, which solder deposit is connected so as to have its free contact surface X facing the contact surface D, by means of the fixing agent applied from the fixing agent composition, or according to claim 3 or 5 in the form of an arrangement consisting of a first component comprising a contact surface A and a second component comprising a contact surface D and a solder deposit that is arranged between the contact surfaces A and D and that is connected to the contact surface D, which solder deposit is connected so as to have its free contact surface Y facing the contact surface A, by means of the fixing agent applied from the fixing agent composition.

## Revendications

1. Procédé pour la production d'un ensemble sandwich composé d'un premier composant comportant une surface de contact A, d'un second composant comportant une surface de contact D et d'une soudure située entre les surfaces de contact A et D, la soudure étant produite par la fusion d'un dépôt de soudure disposé entre les deux composants et lié à un des composants au niveau de la surface de contact A ou D et par le refroidissement subséquent de la soudure fondue en dessous de sa température de solidification,
le dépôt de soudure étant produit antérieurement par la fusion d'une préforme de soudure fixée au moyen d'un agent fixant appliqué à partir d'une composition d'agent fixant à la surface de contact A ou D concernée et par le refroidissement subséquent de la soudure fondue en dessous de sa température de solidification, et le dépôt de soudure étant disposé faisant face avec sa surface de contact libre à la surface de contact D ou A correspondante du composant encore non lié,
la composition d'agent fixant étant constituée
de 0 à 97 % en poids d'au moins un solvant choisi dans le groupe composé d'eau et de solvants organiques dont la température d'ébullition est ≤ 285 °C,
de 3 à 100 % en poids d'au moins un matériau M1 choisi dans le groupe composé de (i) polymères organiques thermoplastiques fusibles dans la plage de 30 à 180 °C et de (ii) composés organiques non polymères fusibles dans la plage de 30 à 180 °C et dépourvus de groupes acides, choisis parmi les lactames et les alcools gras,
de 0 à 20 % en poids d'au moins un matériau M2 choisi dans le groupe composé de (iii) polymères organiques non fusibles dans la plage de 30 à 180 °C et de (iv) composés organiques non polymères non fusibles dans la plage de 30 à 180 °C et dépourvus de groupes acides et sans point d'ébullition ou avec un point d'ébullition supérieur à 285 °C et
de 0 à 30 % en poids d'une ou plusieurs charges solides inorganiques, et la somme des parties de surfaces munies de l'agent fixant des surfaces de contact A et B, respectivement C et D, formant ensemble, lors de la mise en place de la préforme de soudure une surface de chevauchement commune étant de 1500 µm² à 50 % en surface de la surface de chevauchement commune.

2. Procédé selon la revendication 1, comprenant les étapes consécutives suivantes :
(1) fourniture d'un premier composant comportant une surface de contact A, d'un second composant comportant une surface de contact D, de la composition d'agent fixant ainsi que d'une préforme de soudure comportant des surfaces de contact B et C discrètes respectivement non munies d'agent fixant,
(2) application de l'agent fixant à partir de la composition d'agent fixant sur les surfaces de contact A et/ou B,
(3) mise en place de la préforme de soudure avec sa surface de contact B sur la surface de contact A avec l'agent fixant entre les surfaces de contact A et B,
(4) fusion de la préforme de soudure fixée avec la formation d'une soudure fondue,
(5) refroidissement de la soudure fondue en dessous de sa température de solidification avec la formation d'un dépôt de soudure comportant une surface de contact X libre,
(6) le cas échéant, application de l'agent fixant à partir de la composition d'agent fixant sur les surfaces de contact D et/ou X,
(7) production d'un ensemble sandwich à partir des deux composants comportant le dépôt de soudure situé entre eux par la disposition des surfaces de contact X et D en position se faisant face avec l'agent fixant situé entre elles le cas échéant,
(8) fusion du dépôt de soudure avec la formation d'une soudure fondue et
(9) refroidissement de la soudure fondue en dessous de sa température de solidification avec la formation d'un ensemble sandwich à partir des deux composants liés par leurs surfaces de contact A et D et la soudure solidifiée située entre elles.

3. Procédé selon la revendication 1, comprenant les étapes consécutives suivantes
(1) fourniture d'un premier composant comportant une surface de contact A, d'un second composant comportant une surface de contact D, de la composition d'agent fixant ainsi que d'une préforme de soudure comportant des surfaces de contact B et C discrètes respectivement non munies d'agent fixant,
(2) application de l'agent fixant à partir de la composition d'agent fixant sur les surfaces de contact C et/ou D,
(3) mise en place de la préforme de soudure avec sa surface de contact C sur la surface de contact D avec l'agent fixant entre les surfaces de contact C et D,
(4) fusion de la préforme de soudure fixée avec la formation d'une soudure fondue,
(5) refroidissement de la soudure fondue en dessous de sa température de solidification avec la formation d'un dépôt de soudure comportant une surface de contact Y libre,
(6) le cas échéant, application de l'agent fixant à partir de la composition d'agent fixant sur les surfaces de contact A et/ou Y,
(7) production d'un ensemble sandwich à partir des deux composants avec le dépôt de soudure situé entre eux par la disposition des surfaces de contact Y et A en position se faisant face avec l'agent fixant situé entre elles le cas échéant,
(8) fusion du dépôt de soudure avec la formation d'une soudure fondue et
(9) refroidissement de la soudure fondue en dessous de sa température de solidification avec la formation d'un ensemble sandwich à partir des deux composants liés par leurs surfaces de contact A et D et la soudure solidifiée située entre elles.

4. Procédé selon la revendication 1, comprenant les étapes consécutives suivantes :
(1) fourniture d'un premier composant comportant une surface de contact A, d'un second composant comportant une surface de contact D, d'une préforme de soudure comportant des surfaces de contact B et C discrètes, dont seule la surface de contact B est munie de l'agent fixant, ainsi que, le cas échéant, de la composition d'agent fixant,
(2) le cas échéant, application de l'agent fixant à partir de la composition d'agent fixant sur la surface de contact A,
(3) mise en place de la préforme de soudure avec sa surface de contact B sur la surface de contact A avec l'agent fixant entre les surfaces de contact A et B,
(4) fusion de la préforme de soudure fixée avec la formation d'une soudure fondue,
(5) refroidissement de la soudure fondue en dessous de sa température de solidification avec la formation d'un dépôt de soudure comportant une surface de contact X libre,
(6) le cas échéant, application de l'agent fixant à partir de la composition d'agent fixant sur les surfaces de contact D et/ou X,
(7) production d'un ensemble sandwich à partir des deux composants comportant le dépôt de soudure situé entre eux par la disposition des surfaces de contact X et D en position se faisant face avec l'agent fixant situé entre elles le cas échéant,
(8) fusion du dépôt de soudure avec la formation d'une soudure fondue et
(9) refroidissement de la soudure fondue en dessous de sa température de solidification avec la formation d'un ensemble sandwich à partir des deux composants liés par leurs surfaces de contact A et D et la soudure solidifiée située entre elles.

5. Procédé selon la revendication 1, comprenant les étapes consécutives suivantes :
(1) fourniture d'un premier composant comportant une surface de contact A, d'un second composant comportant une surface de contact D, d'une préforme de soudure comportant des surfaces de contact B et C discrètes, dont seule la surface de contact C est munie de l'agent fixant, ainsi que, le cas échéant, de la composition d'agent fixant,
(2) le cas échéant, application de l'agent fixant à partir de la composition d'agent fixant sur la surface de contact D,
(3) mise en place de la préforme de soudure avec sa surface de contact C sur la surface de contact D avec l'agent fixant entre les surfaces de contact C et D,
(4) fusion de la préforme de soudure fixée avec la formation d'une soudure fondue,
(5) refroidissement de la soudure fondue en dessous de sa température de solidification avec la formation d'un dépôt de soudure comportant une surface de contact Y libre,
(6) le cas échéant, application de l'agent fixant à partir de la composition d'agent fixant sur les surfaces de contact A et/ou Y,
(7) production d'un ensemble sandwich à partir des deux composants avec le dépôt de soudure situé entre eux par la disposition des surfaces de contact Y et A en position se faisant face avec l'agent fixant situé entre elles le cas échéant,
(8) fusion du dépôt de soudure avec la formation d'une soudure fondue et
(9) refroidissement de la soudure fondue en dessous de sa température de solidification avec la formation d'un ensemble sandwich à partir des deux composants liés par leurs surfaces de contact A et D et la soudure solidifiée située entre elles.

6. Produit intermédiaire du procédé selon la revendication 2 ou 4 sous la forme d'un ensemble composé d'un premier composant comportant une surface de contact A et d'un second composant comportant une surface de contact D et d'un dépôt de soudure disposé entre les surfaces de contact A et D et lié à la surface de contact A, lequel est lié par sa surface de contact X libre faisant face à la surface de contact D au moyen de l'agent fixant appliqué à partir de la composition d'agent fixant, ou selon la revendication 3 ou 5 sous la forme d'un ensemble composé d'un premier composant comportant une surface de contact A et d'un second composant comportant une surface de contact D et d'un dépôt de soudure disposé entre les surfaces de contact A et D et lié à la surface de contact D, lequel est lié par sa surface de contact Y libre faisant face à la surface de contact A au moyen de l'agent fixant appliqué à partir de la composition d'agent fixant.
